# EUROPEAN PATENT APPLICATION

(11) **EP 4 753 400 A1**
(43) Date of publication of application: **03.06.2026**
(21) Application number: 25216554.3
(22) Date of filing: 18.11.2025
(51) Int. Cl.: H10D 30/47, H10D 30/01, H10D 30/00, H10D 62/13, H10D 62/82, H10D 62/80

(54) **SEMICONDUCTOR DEVICE, METHOD OF MANUFACTURING THE SAME, AND ELECTRONIC DEVICE INCLUDING THE SEMICONDUCTOR DEVICE**

(30) Priority: 27.11.2024 KR 20240172763
(71) Applicant: Samsung Electronics Co., Ltd., Suwon-si, Gyeonggi-do 16677 (KR)
(72) Inventor: Kwon, Junyoung, 16678 Suwon-si, Gyeonggi-do (KR); Yoo, Joungeun, 16678 Suwon-si, Gyeonggi-do (KR); Lee, Eunkyu, 16678 Suwon-si, Gyeonggi-do (KR)
(74) Representative: Grünecker Patent- und Rechtsanwälte PartG mbB

(57) **Abstract**

A semiconductor device includes a channel layer including a van der Waals material, a source electrode structure and a drain electrode structure electrically connected to opposite ends of the channel layer, respectively, a gate insulating layer on the channel layer, and a gate electrode on the gate insulating layer, wherein each of the source electrode structure and the drain electrode structure includes an interlayer including a dopant and one of a semiconductor or an insulator, and a metal layer on the interlayer.

## Description

### BACKGROUND

### 1. Field

The inventive concepts relate to semiconductor devices, methods of manufacturing the same, and electronic devices including the semiconductor devices.

### 2. Description of the Related Art

A transistor is a semiconductor device used to switch electrical signals and is used in various integrated circuit (IC) devices including a memory, a driving IC, and a logic device. In order to increase the degree of integration of an IC device, a space occupied by a transistor provided in the IC device has been rapidly reduced. As a result, the channel length of the transistor has been shortened, and thicknesses of layers constituting the transistor have been reduced.

As such, research has been continued to replace a field-effect transistor (FET) channel material with a two-dimensional semiconductor in order to reduce short channel effects, which occur as FET miniaturization progresses, and to improve gate controllability.

Contact resistance between a two-dimensional semiconductor material and a metal electrode is one of the major issues for improving the performance of a two-dimensional semiconductor material-based FET. The two-dimensional semiconductor material is very thin, and thus, there is no doping technology and it is difficult to use a method of lowering contact resistance by doping the two-dimensional semiconductor material.

### SUMMARY

Some example embodiments provide a semiconductor device using a two-dimensional semiconductor material. Some example embodiments provide a method of manufacturing the semiconductor device.

Additional aspects will be set forth in part in the description which follows and, in part, will be apparent from the description, or may be learned by practice of the presented example embodiments.

According to some example embodiments of the inventive concepts, a semiconductor device may include a channel layer including a van der Waals material, a source electrode structure and a drain electrode structure electrically connected to opposite ends of the channel layer, respectively, a gate insulating layer on the channel layer, and a gate electrode on the gate insulating layer. Each of the source electrode structure and the drain electrode structure may include an interlayer including a dopant and a semiconductor or an insulator, and a metal layer on the interlayer.

The channel layer may include a two-dimensional material, graphene, carbon nanotubes, or phosphorene.

The two-dimensional material may include at least one of MoS₂, WS₂, MoSe₂, MoTe₂, WSe₂, WTe₂, ReS₂, ReSe₂, PtS₂, PtSe₂, NbS₂, NbSe₂, SnS₂, SnS, SnSe, or SnSe₂.

The interlayer may include Si, Ge, or a group III-V semiconductor compound.

A doping concentration of the dopant in the interlayer may be 1×10¹³cm⁻³ or more.

A thickness of the interlayer may be 1 nm or less.

In each of the source electrode structure and the drain electrode structure, the metal layer may include a bottom surface facing the channel layer and a side surface extending upward from the bottom surface, and the interlayer may contact the bottom surface and the side surface of the metal layer.

The interlayer may surround a top surface and a bottom surface of one end of the channel layer, and the metal layer may surround the interlayer.

The semiconductor device may further include a seed layer between the channel layer and the gate insulating layer.

The seed layer may be formed of a same material as the interlayer.

The channel layer may include a first channel layer and a second channel layer spaced apart from each other, and the gate electrode may surround each of the first channel layer and the second channel layer.

In each of the source electrode structure and the drain electrode structure, the interlayer may include a first interlayer surrounding one end of the first channel layer, and a second interlayer surrounding one end of the second channel layer.

The gate insulating layer may include a first gate insulating layer surrounding the first channel layer, and a second gate insulating layer surrounding the second channel layer.

The semiconductor device may further include a first seed layer between the first channel layer and the first gate insulating layer and formed of a same material as the first interlayer, and a second seed layer between the second channel layer and the second gate insulating layer and formed of a same material as the second interlayer.

According to some example embodiments of the inventive concepts, a method of manufacturing a display device may include forming a channel layer including a van der Waals material, forming, on the channel layer, an electrode structure including an interlayer including a semiconductor or an insulator and a dopant, forming a gate insulating layer on the channel layer, and forming a gate electrode on the gate insulating layer.

The interlayer may be formed by using physical vapor deposition.

The method may further include forming a seed layer between the channel layer and the gate insulating layer, wherein the seed layer is formed of a same material as the interlayer.

The forming of the electrode structure may be performed after the forming of the gate insulating layer.

The forming of the gate insulating layer may be performed after the forming of the electrode structure.

According to some example embodiments of the inventive concepts, an electronic device may include a semiconductor device, and a controller configured to control the semiconductor device, wherein the semiconductor device may include a channel layer including a van der Waals material, a source electrode structure and a drain electrode structure electrically connected to opposite ends of the channel layer, respectively, a gate insulating layer on the channel layer, and a gate electrode on the gate insulating layer, wherein each of the source electrode structure and the drain electrode structure includes an interlayer including a dopant and one of a semiconductor or an insulator, and a metal layer on the interlayer.

The semiconductor device according to some example embodiments, may exhibit reduced (lowered) contact resistance and reduced size (e.g., reduced thickness) without compromising semiconductor device performance.

### BRIEF DESCRIPTION OF THE DRAWINGS

The above and other aspects, features, and advantages of certain embodiments will be more apparent from the following description taken in conjunction with the accompanying drawings, in which:
FIG. 1 is a cross-sectional view illustrating a schematic structure of a semiconductor device, according to some example embodiments;
FIG. 2 is a cross-sectional view illustrating a schematic structure of a semiconductor device, according to some example embodiments;
FIG. 3 is a cross-sectional view illustrating a schematic structure of a semiconductor device, according to some example embodiments;
FIG. 4 is a cross-sectional view illustrating a schematic structure of a semiconductor device, according to some example embodiments;
FIG. 5 is a cross-sectional view illustrating a schematic structure of a semiconductor device, according to some example embodiments;
FIG. 6 is a cross-sectional view illustrating a schematic structure of a semiconductor device, according to some example embodiments;
FIG. 7 is a cross-sectional view illustrating a schematic structure of a semiconductor device, according to some example embodiments;
FIG. 8 is a cross-sectional view illustrating another cross-section of the semiconductor device of FIG. 7 along line VIII-VIII' in FIG. 7, according to some example embodiments;
FIG. 9 is a cross-sectional view illustrating a schematic structure of a semiconductor device, according to some example embodiments;
FIG. 10 is a cross-sectional view illustrating another cross-section of the semiconductor device of FIG. 9 along line X-X' in FIG. 9, according to some example embodiments;
FIG. 11 is a flowchart schematically illustrating a method of manufacturing a semiconductor device, according to some example embodiments;
FIG. 12 is a schematic block diagram illustrating a display driver integrated circuit (DDI) and a display apparatus including the DDI, according to some example embodiments;
FIG. 13 is a circuit diagram illustrating a complementary metal-oxide-semiconductor (CMOS) inverter, according to some example embodiments;
FIG. 14 is a circuit diagram illustrating a CMOS static random-access memory (SRAM) device, according to some example embodiments;
FIG. 15 is a circuit diagram illustrating a CMOS NAND circuit, according to some example embodiments;
FIG. 16 is a block diagram illustrating an electronic device, according to some example embodiments; and
FIG. 17 is a block diagram illustrating an electronic device, according to some example embodiments.

### DETAILED DESCRIPTION

Reference will now be made in detail to example embodiments, some of which are illustrated in the accompanying drawings, wherein like reference numerals refer to like elements throughout, and sizes of elements may be exaggerated for clarity and convenience of explanation. The embodiments described below are merely examples, and various modifications may be made from the embodiments. In this regard, some example embodiments may have different forms and should not be construed as being limited to the descriptions set forth herein. Accordingly, some example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

When an element is referred to as being "on" another element, it may be directly on the other element, or intervening elements may be present therebetween.

While such terms as "first," "second," etc., may be used to describe various components, the above terms are used only to distinguish one component from another. There terms do not limit that materials or structures of elements are different from each other.

The singular forms "a," "an," and "the" are intended to include the plural forms as well, unless the context clearly indicates otherwise. When a part "includes" an element, another element may be further included, rather than excluding the existence of the other element, unless otherwise described.

Also, in the specification, the term "... unit" or "module" indicates a unit for processing at least one function or operation, and may be implemented by hardware, software, or a combination of hardware and software.

The use of the terms "a" and "an," and "the" and similar referents in the context of describing the inventive concepts is to be construed to cover both the singular and the plural.

The steps of all methods described herein may be performed in any suitable order unless otherwise indicated herein or otherwise clearly contradicted by context. The use of any and all examples, or exemplary language (e.g., "such as") provided herein, is intended merely to better illuminate the inventive concepts and does not pose a limitation on the scope of the inventive concepts unless otherwise claimed.

An expression used in the singular encompasses the expression of the plural, unless it has a clearly different meaning in the context. Unless explicitly described to the contrary, it is to be understood that the terms such as "including" and "having" are intended to indicate the existence of the features, numbers, steps, actions, components, parts, ingredients, materials, or combinations thereof disclosed in the specification and are not intended to preclude the possibility that one or more other features, numbers, steps, actions, components, parts, ingredients, materials, or combinations thereof may exist or may be added.

Whenever a range of values is recited, the range includes all values that fall within the range as if expressly written, and the range further includes the boundaries of the range. Thus, a range of "X to Y" includes all values between X and Y and also includes X and Y.

In order to clearly explain the present inventive concepts in the drawings, parts that are not related to the description are omitted, and similar parts are given similar reference numerals throughout the specification. In the methods described herein, the order of operations may be changed, several operations may be merged, certain operations may be divided, and certain operations may not be performed.

Additionally, expressions written in the singular may be interpreted as singular or plural, unless explicit expressions such as "one" or "single" are used. Terms containing ordinal numbers, such as first, second, etc., may be used to describe various elements, but the elements are not limited by these terms. These terms may be used for the purpose of distinguishing one component from another.

Throughout the specification, the term "connected" does not mean only that two or more constituent components are directly connected, but may also mean that two or more constituent components are indirectly connected through another constituent component. In addition, unless explicitly described to the contrary, the word "comprise", and variations such as "comprises" or "comprising", will be understood to imply the inclusion of stated elements but not the exclusion of any other elements.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is referred to as being "above" or "on" a reference element, it can be positioned above or below the reference element, and it is not necessarily referred to as being positioned "above" or "on" in a direction opposite to gravity.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular", "substantially parallel", or "substantially coplanar" with regard to other elements and/or properties thereof will be understood to be "perpendicular", "parallel", or "coplanar", respectively, with regard to the other elements and/or properties thereof within manufacturing tolerances and/or material tolerances and/or have a deviation in magnitude and/or angle from "perpendicular", "parallel", or "coplanar", respectively, with regard to the other elements and/or properties thereof that is equal to or less than 10% (e.g., a. tolerance of ±10%).

It will be understood that elements and/or properties thereof may be recited herein as being "identical", "the same", or "equal" as other elements and/or properties thereof, and it will be further understood that elements and/or properties thereof recited herein as being "identical" to, "the same" as, or "equal" to other elements and/or properties thereof may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to, equal to or substantially equal to, and/or the same or substantially the same as other elements and/or properties thereof may be structurally the same or substantially the same, functionally the same or substantially the same, and/or compositionally the same or substantially the same. While the term "same," "equal" or "identical" may be used in description of some example embodiments, it should be understood that some imprecisions may exist. Thus, when one element or property is referred to as being identical to, equal to, or the same as another element or property, it should be understood that the element or property is the same as another element or property within a desired manufacturing or operational tolerance range (e.g., ±10%).

It will be understood that elements and/or properties thereof described herein as being "substantially" the same, equal, and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

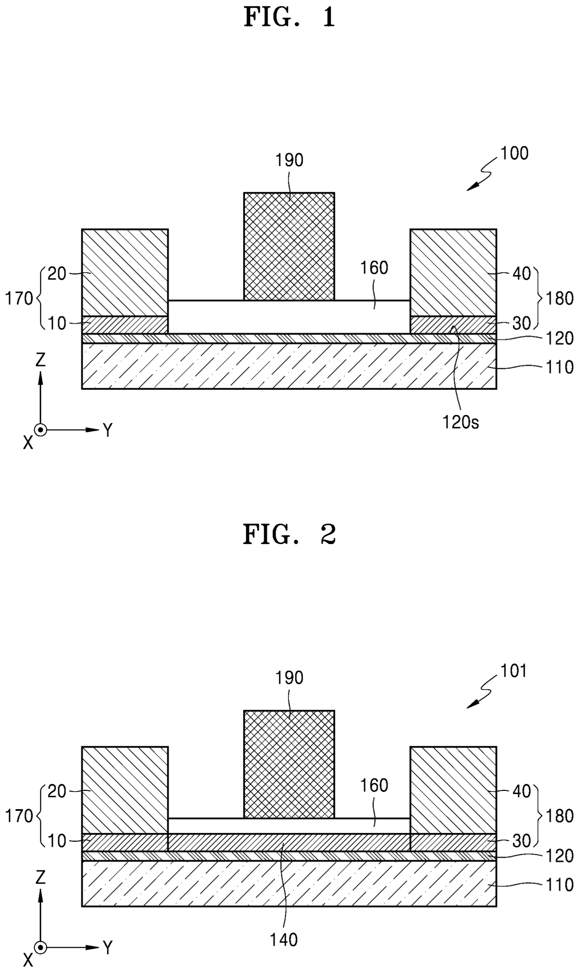

FIG. 1 is a cross-sectional view illustrating a schematic structure of a semiconductor device, according to some example embodiments.

A semiconductor device 100 includes a channel layer 120, a source electrode structure 170, a drain electrode structure 180, a gate insulating layer 160, and a gate electrode 190. The channel layer 120 may be disposed on a substrate 110. The semiconductor device 100 may be a field-effect transistor.

The substrate 110 may be an insulating substrate, or a semiconductor substrate having a surface on which an insulating layer is formed. The semiconductor substrate may include, for example, Si, Ge, SiGe, or a group III-V semiconductor material. The substrate 110 may be, for example, but is not limited to, a silicon substrate having a surface on which silicon oxide is formed.

The channel layer 120 may be disposed on the substrate 110 and may be in contact with an insulating material included in the substrate 110. The channel layer 120 includes a van der Waals material. The van der Waals material is a material for forming a van der Waals surface. The channel layer 120 may include, for example, a two-dimensional material, graphene, carbon nanotubes, phosphorene, or amorphous boron nitride. The material has excellent electrical properties and may maintain high mobility (e.g., high charge mobility) without significantly changing its properties even when a thickness is reduced to a nano-scale. For example, the material may enable the semiconductor device 100 to be reduced in size (e.g., based on the channel layer 120 having a nano-scale thickness) without compromising performance of the semiconductor device 100.

The channel layer 120 may include a transition metal dichalcogenide (TMD) material, which is a two-dimensional semiconductor material. TMD may include a metal element selected from the group consisting of Mo, W, Nb, V, Ta, Ti, Zr, Hf, Tc, Re, Cu, Ga, In, Sn, Ge, and Pb and a chalcogen element selected from the group consisting of S, Se, and Te. The channel layer 120 may include, for example, at least one of MoS₂, WS₂, MoSe₂, MoTe₂, WSe₂, WTe₂, ReS₂, ReSe₂, PtS₂, PtSe₂, NbS₂, NbSe₂, SnS₂, SnS, SnSe, or SnSe₂. The channel layer 120 may be doped with a p-type dopant or an n-type dopant in order to adjust mobility. The p-type dopant and the n-type dopant may be, for example, a p-type dopant and an n-type dopant used for graphene or carbon nanotubes (CNT). The p-type dopant or the n-type dopant may be doped by using ion implantation or chemical doping.

The use of the van der Waals material for the channel layer 120 is to implement a thin thickness suitable for a short channel length when the semiconductor device 100 is applied as a field-effect transistor. A channel length refers to a length of the channel layer 120 in a direction (Y direction) in which the source electrode structure 170 and the drain electrode structure 180 are spaced apart from each other. A channel length gradually decreases in accordance with the recent trend of miniaturization of an electronic device. It is known that problems caused by a short channel effect occur as a channel length decreases. In order to reduce, minimize, or prevent these problems and effectively reduce a channel length, it is advantageous to reduce a thickness of the channel layer 120.

Although the channel layer 120 is a monolayer in FIG. 1, the inventive concepts are not limited thereto, and the channel layer 120 may have a multi-layer or trilayer structure. Each of layers constituting the channel layer 120 may have an atomic-level thickness. The number (quantity) of layers may be set considering channel performance and total thickness.

A thickness of the channel layer 120 may be about 10 nm or less, about 5 nm or less, or about 3 nm or less. A channel length may be about 10 nm or less or about 8 nm or less. In some example embodiments, a channel length may be about 7 nm or less, about 5 nm or less, or about 3 nm or less. A thickness of the channel layer 120 may be about 0.01 nm or more, about 0.1 nm or more, about 1 nm or more, or about 2 nm or more. However, the inventive concepts are not limited thereto.

The source electrode structure 170 and the drain electrode structure 180 may be formed to be electrically connected to both ends (also referred to as "opposite ends") of the channel layer 120, respectively, such that each structure of the source electrode structure 170 and the drain electrode structure 180 is electrically connected to a separate one of the opposite ends of the channel layer 120, as shown in at least FIG. 1. The source electrode structure 170 and the drain electrode structure 180 may be formed to be electrically connected to and on (e.g., directly or indirectly on) both ends (also referred to as "opposite ends") of the channel layer 120, respectively.

The source electrode structure 170 includes an interlayer 10 and a metal layer 20. The interlayer 10 may include a semiconductor or an insulator, and may include a dopant doped into such a material. A doping concentration of the dopant in the interlayer 10 may be, for example, but is not limited to, 1×10¹³cm⁻³ or more. The interlayer 10 may include Si, Ge, or a group III-V semiconductor compound. The dopant may be a material that is capable of transferring electrons or holes (referred to collectively herein as "charge carriers") in relation to a material of the interlayer 10. For example, when the interlayer 10 includes Si, B may be used as a p-type dopant and N or As may be used as an n-type dopant. The interlayer 10 may be formed to contact the channel layer 120. The interlayer 10 may be formed to contact one end of a top surface 120s of the channel layer 120.

The interlayer 10 may include a material that may be formed by using physical vapor deposition (PVD). In other words, the interlayer 10 may be formed by using PVD. The interlayer 10 may be formed by using, for example, thermal evaporation or e-beam evaporation, or may be formed by using sputtering. However, the inventive concepts are not limited thereto, and as long as a desired dopant may be appropriately added to the interlayer 10, the interlayer 10 may be formed by using a method such as atomic layer deposition (ALD) or chemical vapor deposition (CVD).

The metal layer 20 is disposed on the interlayer 10. The metal layer 20 may be formed to contact the interlayer 10. The metal layer 20 may include a metal material having excellent electrical conductivity. For example, the metal layer 20 may include a metal including magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), or bismuth (Bi), or any alloy thereof.

A thickness of the interlayer 10 may be greater than 0 and equal to or less than 2 nm. For example, a thickness of the interlayer 10 may be 1.5 nm or less, or 1 nm or less. A thickness of the interlayer may be about 0.01 nm or more, about 0.1 nm or more, or about 0.5 nm or more. However, the inventive concepts are not limited thereto.

The drain electrode structure 180 also includes an interlayer 30 and a metal layer 40, like the source electrode structure 170. The description of the interlayer 10 and the metal layer 20 of the source electrode structure 170 may apply to the interlayer 30 and the metal layer 40.

Such configurations of the source electrode structure 170 and the drain electrode structure 180 are suggested to reduce contact resistance with the channel layer 120.

In a structure where a two-dimensional semiconductor material and a metal material directly contact each other, a metal-induced gap state is formed and a Fermi level is pinned to a semiconductor deep level state. Accordingly, a high Schottky barrier is formed and contact resistance is increased.

It is generally known that doping a van der Waals material of the channel layer 120 with a dopant is very difficult. This is because the van der Waals material is very thin so that when the dopant is added, a lattice structure may be deformed and the mobility of the channel layer 120 may be drastically reduced. Accordingly, it is difficult to use a method of reducing contact resistance by doping an area of the channel layer 120 contacting an electrode, that is, a contact area of the channel layer 120.

Due to the interlayers 10 and 30 provided in the source electrode structure 170 and the drain electrode structure 180, Fermi level pinning may be reduced, minimized, or prevented and a low Schottky barrier may be formed. Accordingly, very low contact resistance may be achieved, and thus the performance of the semiconductor device 100 may be improved, compared to a case where the interlayers 10 and 30 are not provided.

The gate insulating layer 160 is disposed on the channel layer 120. The gate insulating layer 160 may include various types of insulating materials. The insulating materials may include a high-k dielectric material, which is a material with a high dielectric constant, and may include at least one of aluminum oxide, hafnium oxide, zirconium hafnium oxide, or lanthanum oxide. However, the inventive concepts are not limited thereto. The insulating materials may include a ferroelectric material. The ferroelectric material has a spontaneous electric dipole, i.e., spontaneous polarization due to a non-centrosymmetric charge distribution in a unit cell in a crystallized material structure. Accordingly, the ferroelectric material has remnant polarization due to the dipole, even in the absence of an external electric field. Also, the direction of polarization may be switched on a domain basis by the external electric field. The ferroelectric material may include at least one oxide selected from among, for example, but not limited to, Hf, Si, Al, Zr, Y, La, Gd, and Sr. Also, the ferroelectric material may further include a dopant, when necessary.

When a ferroelectric material is used as a gate insulating material, the semiconductor device 100 may be a field-effect transistor applied as a logic device or a memory device. Because subthreshold swing (SS) may be lowered due to a negative capacitance effect of the ferroelectric material, the semiconductor device 100 may operate as a field-effect transistor with a reduced size and improved performance. For example, the semiconductor device 100 may have reduced size without compromising performance of the semiconductor device 100.

A multi-layer structure including a high-k material and a ferroelectric material may be used as a gate insulating material.

The gate insulating layer 160 may be formed by using ALD. A thickness of the gate insulating layer 160 may be about 10 nm or less, or 5 nm or less. However, the inventive concepts are not limited thereto.

The gate electrode 190 is disposed on the gate insulating layer 160. The gate electrode 190 may include a metal material or a conductive oxide. The metal material may include at least one selected from the group consisting of, for example, Au, Ti, TiN, TaN, W, Mo, WN, Pt, and Ni. The conductive oxide may include, for example, indium tin oxide (ITO) or indium zinc oxide (IZO).

Although the gate electrode 190 is a monolayer in FIG. 1, this is only an example, and the gate electrode 190 may have a multi-layer structure including material layers in addition to an electrode material.

FIG. 2 is a cross-sectional view illustrating a schematic structure of a semiconductor device, according to some example embodiments.

A semiconductor device 101 of some example embodiments, including the example embodiments shown in FIG. 2, is different from the semiconductor device 100 of FIG. 1 in that a seed layer 140 is further provided between (e.g., directly between) the channel layer 120 and the gate insulating layer 160. The seed layer 140 may be formed of the same material as the interlayers 10 and 30. The seed layer 140 may have the same thickness as the interlayers 10 and 30. The seed layer 140 may be formed together when the interlayers 10 and 30 are formed.

Because the channel layer 120 including a van der Waals material has chemical bonding only in-plane and is chemically noble in an out-of-plane direction, it is difficult to conformally deposit a dielectric material directly on the channel layer 120. For example, when ALD, which is mainly used to deposit a dielectric material, is used, it is difficult to generate initial nuclei, and thus a conformal thin film is not formed.

The seed layer 140 is formed thinly on the channel layer 120 by using physisorption, and may function as a nuclei seeding layer for forming the gate insulating layer 160.

In the semiconductor device 101 of some example embodiments, including the example embodiments shown in FIG. 2, the seed layer 140 may also function as a doping layer for supplying charge carriers to the channel layer 120.

The seed layer 140 formed to contact the channel layer 120 may transfer electrons or holes to the channel layer 120. Also, because the amount of electrons or holes transferred to the channel layer 120 may be adjusted according to a doping concentration of the seed layer 140, a doping concentration of the channel layer 120 may be adjusted in various ways. A threshold voltage of the semiconductor device 101 may be adjusted according to a doping concentration of the channel layer 120.

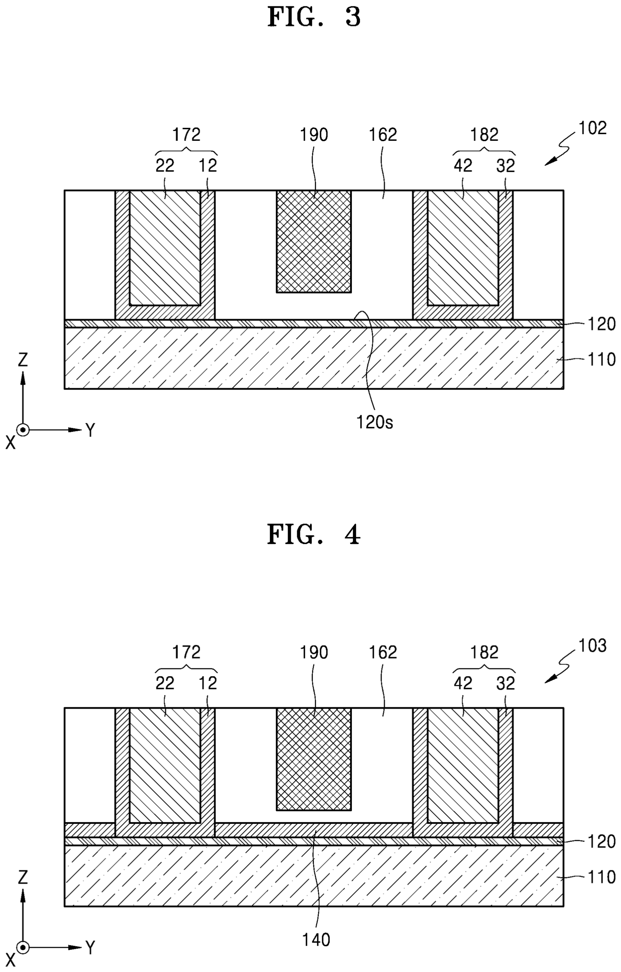

FIG. 3 is a cross-sectional view illustrating a schematic structure of a semiconductor device, according to some example embodiments.

A semiconductor device 102 of some example embodiments, including the example embodiments shown in FIG. 3, is different from the semiconductor device 100 of FIG. 1 in detailed shapes of a source electrode structure 172, a drain electrode structure 182, and the gate insulating layer 160.

The source electrode structure 172 includes an interlayer 12 and a metal layer 22. The interlayer 12 may be formed to contact a bottom surface and a side surface of the metal layer 22. The bottom surface of the metal layer 22 is a surface facing the channel layer 120 (e.g., opposing and extending parallel to the top surface 120s of the channel layer 120), and the side surface of the metal layer 22 is a surface extending upward from the bottom surface (e.g., extending perpendicular to the top surface 120s of the channel layer 120).

The drain electrode structure 182 also includes an interlayer 32 and a metal layer 42 having shapes and materials similar to those of the source electrode structure 172.

Such shapes of the source electrode structure 172 and the drain electrode structure 182 may be formed according to a manufacturing process of forming a gate insulating layer 162 on the channel layer 120 and etching the gate insulating layer 162 to a certain depth of a pattern corresponding to the source electrode structure 172, the drain electrode structure 182, and the gate electrode 190.

FIG. 4 is a cross-sectional view illustrating a schematic structure of a semiconductor device, according to some example embodiments.

A semiconductor device 103 of some example embodiments, including the example embodiments shown in FIG. 4, is different from the semiconductor device 102 of FIG. 3 in that the seed layer 140 formed between (e.g., directly between) the channel layer 120 and the gate insulating layer 162 is further included.

The seed layer 140 may be formed of the same material as the interlayers 12 and 32.

Such a structure of the semiconductor device 103 may be formed according to a manufacturing process of forming the seed layer 140 on the channel layer 120, forming the gate insulating layer 162 on the seed layer 140, and etching the gate insulating layer 162 to a certain depth of a pattern corresponding to the source electrode structure 172, the drain electrode structure 182, and the gate electrode 190. As described above, the seed layer 140 may function as a nuclei seeding layer for forming the gate insulating layer 162, and may protect the channel layer 120 when the gate insulating layer 162 is etched to a depth corresponding to the source electrode structure 172 and the drain electrode structure 182.

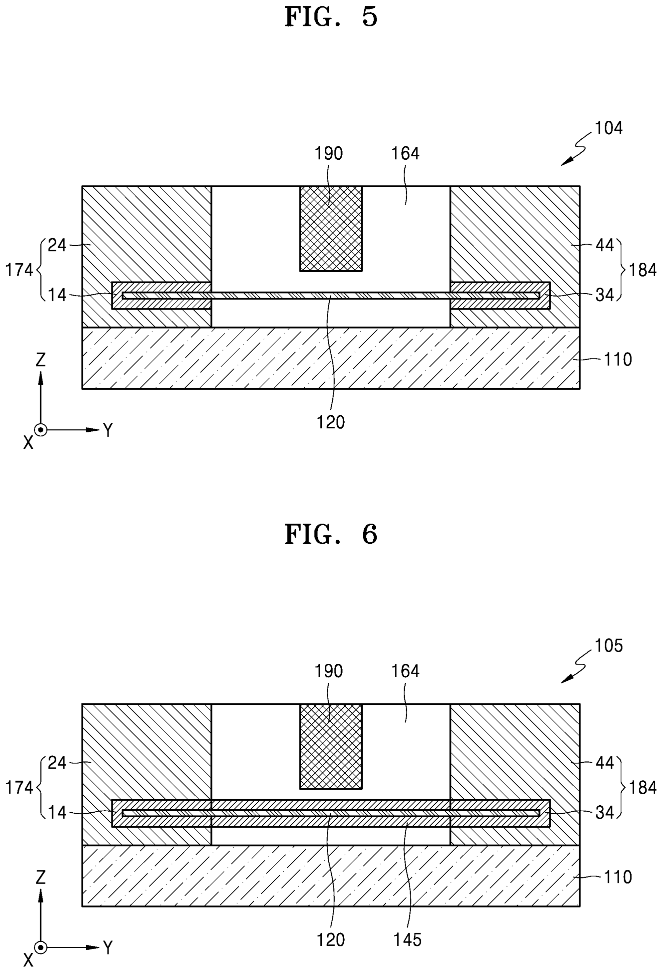

FIG. 5 is a cross-sectional view illustrating a schematic structure of a semiconductor device, according to some example embodiments.

A semiconductor device 104 includes the channel layer 120, a source electrode structure 174, a drain electrode structure 184, a gate insulating layer 164, and the gate electrode 190.

The source electrode structure 174 includes an interlayer 14 and a metal layer 24. The interlayer 14 is formed to surround a top surface and a bottom surface of one end of the channel layer 120, and the metal layer 24 is formed to surround the interlayer 14.

The drain electrode structure 184 includes an interlayer 34 and a metal layer 44 having shapes and materials similar to those of the source electrode structure 174. The interlayer 34 is formed to surround a top surface and a bottom surface of the other end of the channel layer 120, and the metal layer 44 is formed to surround the interlayer 32.

FIG. 6 is a cross-sectional view illustrating a schematic structure of a semiconductor device, according to some example embodiments.

A semiconductor device 105 of some example embodiments, including the example embodiments shown in FIG. 6, is different from the semiconductor device 104 of FIG. 5 in that a seed layer 145 formed between (e.g., directly between) the channel layer 120 and the gate insulating layer 164 is further included.

The seed layer 145 may be formed of the same material as the interlayers 14 and 34.

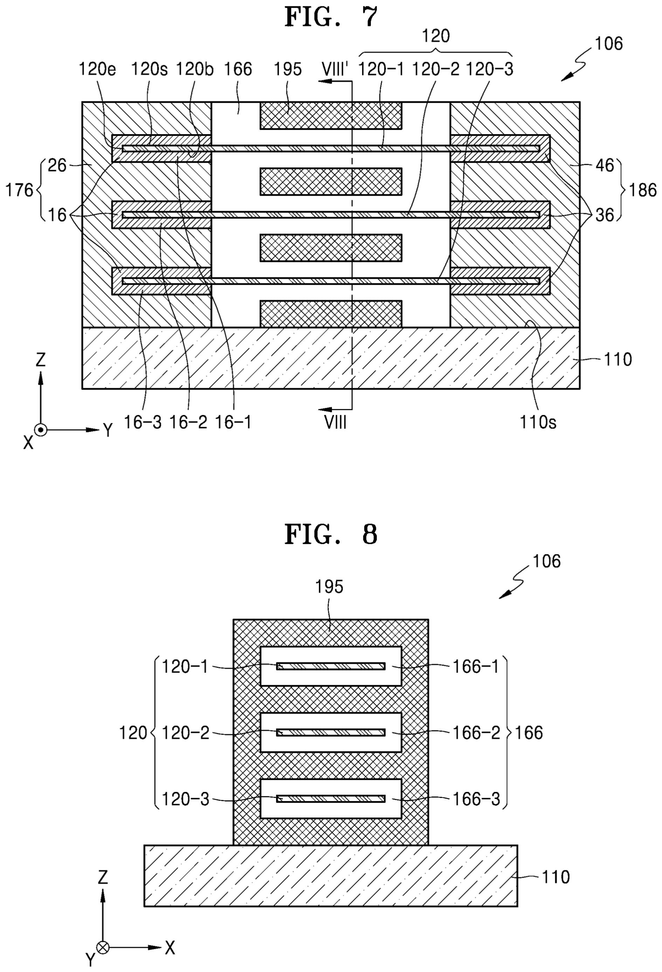

FIG. 7 is a cross-sectional view illustrating a schematic structure of a semiconductor device, according to some example embodiments. FIG. 8 is a cross-sectional view illustrating another cross-section of the semiconductor device of FIG. 7 along line VIII-VIII' in FIG. 7, according to some example embodiments.

A semiconductor device 106 is a gate-all-around (GAA) multi-bridge channel field-effect transistor.

The semiconductor device 106 includes the substrate 110, a plurality of channel layers 120 disposed on the substrate 110, and a gate electrode 195 spaced apart from each of the plurality of channel layers 120 and surrounding each of the plurality of channel layers 120. The plurality of channel layers 120 (e.g., a first channel layer 120-1, a second channel layer 120-2, and a third channel layer 120-3) may be spaced apart from each other along a direction (Z direction) away from the substrate 110. The Z direction may extend perpendicular to a top surface 110s of the substrate 110. A plurality of gate insulating layers 166 (e.g., a first gate insulating layer 166-1, a second gate insulating layer 166-2, and a third gate insulating layer 166-3) surrounding the plurality of channel layers 120 (e.g., such that, in at least a plane such as the XZ shown in FIG. 8, the first gate insulating layer 166-1 surrounds the first channel layer 120-1, the second gate insulating layer 166-2 surrounds the second channel layer 120-2, and the third gate insulating layer 166-3 surrounds the third channel layer 120-3) may be disposed between the gate electrodes 195 and the plurality of channel layers 120. Although the number (quantity) of channel layers 120 is 3, the inventive concepts are not limited thereto, and the number of channel layers 120 may be 2 or more.

A source electrode structure 176 electrically connected to one end of the plurality of channel layers 120 and a drain electrode structure 186 electrically connected to the other end (e.g., opposite end) of the plurality of channel layers 120 may both be disposed on (e.g., directly on) the substrate 110.

The source electrode structure 176 includes a plurality of interlayers 16 (e.g., a first interlayer 16-1, a second interlayer 16-2, and a third interlayer 16-3) surrounding (e.g., contacting) top surfaces 120s and bottom surfaces 120b and side edges 120e of one end of the plurality of channel layers 120 (e.g., such that the first interlayer 16-1 surrounds one end of the first channel layer 120-1, the second interlayer 16-2 surrounds one end of the second channel layer 120-2, and the third interlayer 16-3 surrounds one end of the third channel layer 120-3) and a metal layer 26 formed to surround the plurality of interlayers 16. The metal layer 26 may be formed to contact the plurality of interlayers 16.

The drain electrode structure 186 also includes a plurality of interlayers 36 and a metal layer 46 having shapes and materials similar to those of the source electrode structure 176. The metal layer 46 may be formed to contact the plurality of interlayers 36.

The description of the substrate 110, the channel layer 120, the interlayers 10 and 30, the metal layers 20 and 40, the gate insulating layer 160, and the gate electrode 190 of FIG. 1 may apply to the substrate 110, the channel layer 120, the interlayers 16 and 36, the metal layers 26 and 46, the gate insulating layer 166, and the gate electrode 195.

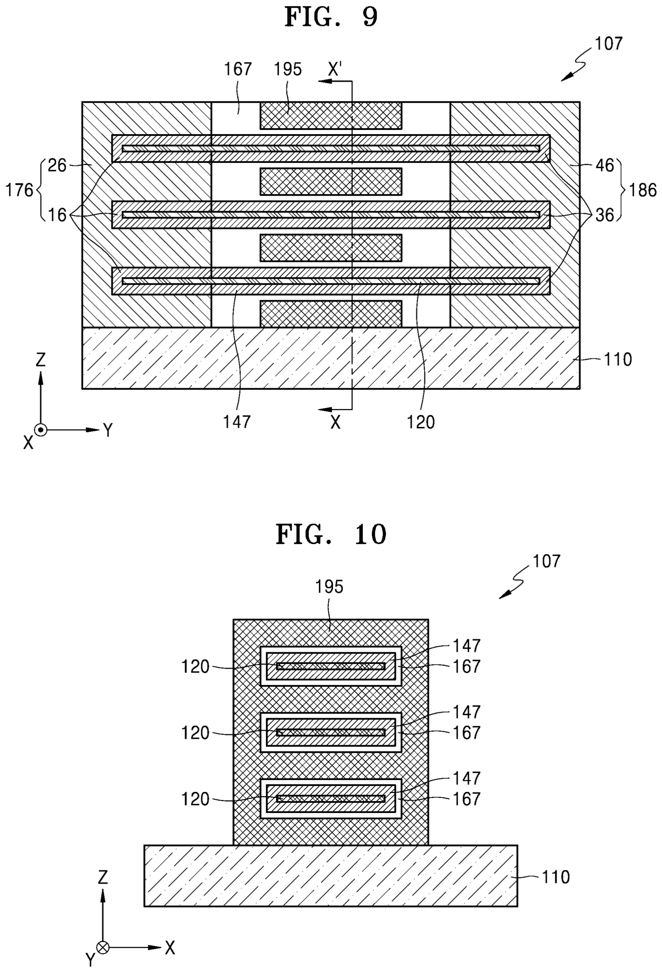

FIG. 9 is a cross-sectional view illustrating a schematic structure of a semiconductor device, according to some example embodiments. FIG. 10 is a cross-sectional view illustrating another cross-section of the semiconductor device of FIG. 9 along line X-X' in FIG. 9, according to some example embodiments.

A semiconductor device 107 of some example embodiments, including the example embodiments shown in FIGS. 9 and 10 is different from the semiconductor device 106 of FIG. 7 in that a seed layer 147 is further provided.

The seed layer 147 may be formed to surround the channel layer 120 between (e.g., directly between) the channel layer 120 and a gate insulating layer 167. The seed layer 147 may be formed of the same material as the interlayers 16 and 36.

As described above, the seed layer 147 may supply charge carriers to the channel layer 120, and a threshold voltage of a transistor of the semiconductor device 107 may be adjusted according to a doping concentration of the seed layer 147.

According to some example embodiments, the semiconductor device may include a plurality of transistors having different threshold voltages. Each of the plurality of transistors may be any one of the semiconductor devices 100, 101, 102, 103, 104, 105, 106, and 107 described above. The plurality of transistors may have different threshold voltages by adjusting a material or a doping concentration of the channel layer. The plurality of transistors may be, for example, the semiconductor devices 101, 103, 105, and 107 including a seed layer, and in this case, the plurality of transistors may have different threshold voltages by adjusting a doping concentration of the seed layer.

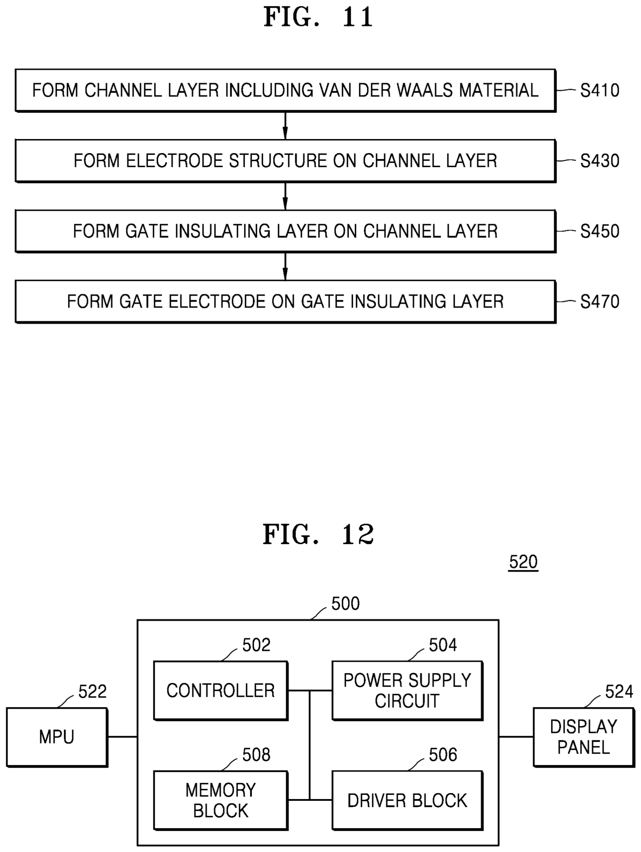

FIG. 11 is a flowchart schematically illustrating a method of manufacturing a semiconductor device, according to some example embodiments.

The method of manufacturing a semiconductor device includes a step of forming a channel layer including a van der Waals material (S410), a step of forming, on the channel layer, an electrode structure including an interlayer including a semiconductor or an insulator and a dopant (S430), a step of forming a gate insulating layer on the channel layer (S450), and a step of forming a gate electrode on the gate insulating layer (S470).

The description of the channel layer, the interlayer, the gate insulating layer, and the gate electrode may apply to materials and structures of the channel layer, the interlayer, the gate insulating layer, and the gate electrode manufactured in each step.

The channel layer may be formed by using a method such as metal organic CVD (MOCVD) or ALD.

The interlayer may be formed by using PVD. For example, the interlayer may be formed by evaporating a target material obtained by doping a dopant of a certain type and concentration into a semiconductor material. The interlayer may be formed by using, for example, thermal evaporation or e-beam evaporation, or may be formed by using sputtering. However, the inventive concepts are not limited thereto, and as long as a dopant may be appropriately added to the interlayer, the interlayer may be formed by using a method such as ALD or CVD.

A step of forming a seed layer between the channel layer and the gate insulating layer may be further performed. The seed layer may be formed of the same material as the interlayer.

Detailed processes may be further added or changed according to a specific type of a semiconductor device to be manufactured, for example, whether the semiconductor device is a planar-type semiconductor device or a GAA-type semiconductor device, or whether a seed layer is provided. The steps illustrated in FIG. 11 are not limited to the order illustrated. For example, in the GAA-type semiconductor device, the step of forming the electrode structure (S430) may be performed after the step of forming the gate insulating layer (S450), and in the planar-type semiconductor device, the step of forming the gate insulating layer (S450) may be performed after the step of forming the electrode structure (S430). However, the inventive concepts are not limited thereto.

The semiconductor device according to some example embodiments, and the semiconductor device provided according to the manufacturing method according to some example embodiments may exhibit good electrical performance and/or improved performance with an ultra-small structure and thus may be applied to an integrated circuit device. The semiconductor device according to some example embodiments may be used as a logic transistor, and may be applied to various electronic devices together with a controller for controlling the logic transistor.

The semiconductor devices 100, 101, 102, 103, 104, 105, 106, and 107 may be used, for example, in a driving integrated circuit of a display, a CMOS inverter, a CMOS SRAM device, a CMOS NAND circuit, and/or various other electronic devices.

FIG. 12 is a schematic block diagram illustrating a display driver integrated circuit (IC) (DDI) 500 and a display apparatus 520 including the DDI, according to some example embodiments.

Referring to FIG. 12, a DDI 500 of the display apparatus 520 may include a controller 502, a power supply circuit 504, a driver block 506, and a memory block 508. The controller 502 receives and decodes a command applied from a main processing unit (MPU) 522 of the display apparatus 520, and controls each block of the DDI 500 to implement an operation according to the command. The power supply circuit 504 generates a driving voltage in response to control of the controller 502. The driver block 506 drives a display panel 524 of the display apparatus 520 by using the driving voltage generated by the power supply circuit 504 in response to control of the controller 502. The display panel 524 may be, for example, a liquid crystal display panel, an organic light-emitting device (OLED) display panel, or a plasma display panel. The memory block 508 is a block that temporarily stores a command input to the controller 502 or control signals output from the controller 502, or stores necessary data, and may include a memory such as random-access memory (RAM) or read-only memory (ROM). At least one of the controller 502, the power supply circuit 504, the driver block 506, or the memory block 508 may include any one of the semiconductor devices 100 to 107 according to some example embodiments described above or any modified combination thereof.

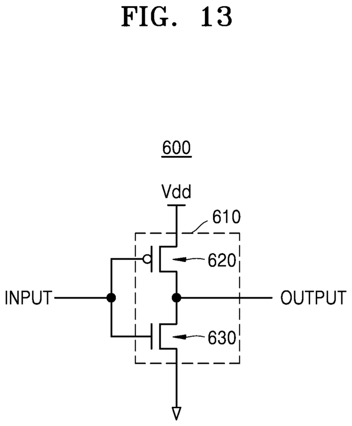

FIG. 13 is a circuit diagram illustrating a complementary metal-oxide-semiconductor (CMOS) inverter, according to some example embodiments.

Referring to FIG. 13, a CMOS inverter 600 includes a CMOS transistor 610. The CMOS transistor 610 includes a P-channel MOS (PMOS) transistor 620 and an N-channel MOS (NMOS) transistor 630 connected between a power supply terminal Vdd and a ground terminal. The CMOS transistor 610 may include any one of the semiconductor devices 100 to 107 according to some example embodiments described above or any modified combination thereof.

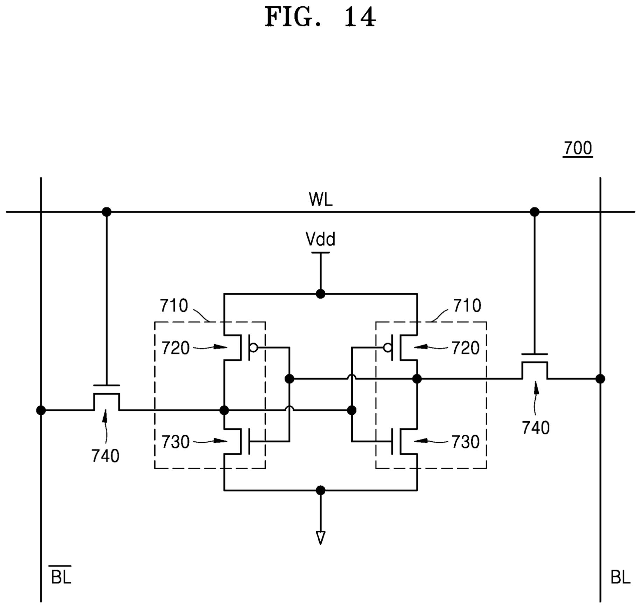

FIG. 14 is a circuit diagram illustrating a CMOS static random-access memory (SRAM) device 700, according to some example embodiments.

Referring to FIG. 14, the CMOS SRAM device 700 includes one pair of driving transistors 710. Each driving transistor 710 includes a PMOS transistor 720 and an NMOS transistor 730 connected between a power supply terminal Vdd and a ground terminal. The CMOS SRAM device 700 may further include one pair of transfer transistors 740. A source of the transfer transistor 740 is cross-connected to a common node of the PMOS transistor 720 and the NMOS transistor 730 constituting the driving transistor 710. The power supply terminal Vdd is connected to a source of the PMOS transistor 720, and the ground terminal is connected to a source of the NMOS transistor 730. A word line WL may be connected to gates of the one pair of transfer transistors 740, and a bit line BL and an inverted bit line may be respectively connected to drains of the one pair of transfer transistors 740. At least one of the driving transistor 710 or the transfer transistor 740 of the CMOS SRAM device 700 may include any one of the semiconductor devices 100 to 107 according to some example embodiments described above or any modified combination thereof.

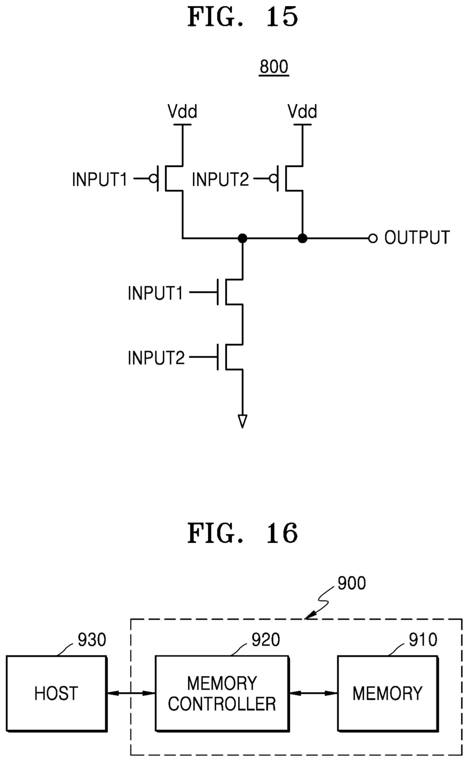

FIG. 15 is a circuit diagram illustrating a CMOS NAND circuit, according to some example embodiments.

Referring to FIG. 15, a CMOS NAND circuit 800 includes one pair of CMOS transistors to which different input signals are transmitted. The CMOS NAND circuit 800 may include any one of the semiconductor devices 100 to 107 according to some example embodiments described above or any modified combination thereof.

FIG. 16 is a block diagram illustrating an electronic device, according to some example embodiments.

Referring to FIG. 16, an electronic device 900 includes a memory 910 and a memory controller 920. The memory controller 920 may control the memory 910 to read data from the memory 910 and/or write data to the memory 910 in response to a request of a host 930. At least one of the memory 910 or the memory controller 920 may include any one of the semiconductor devices 100 to 107 according to some example embodiments described above or any modified combination thereof.

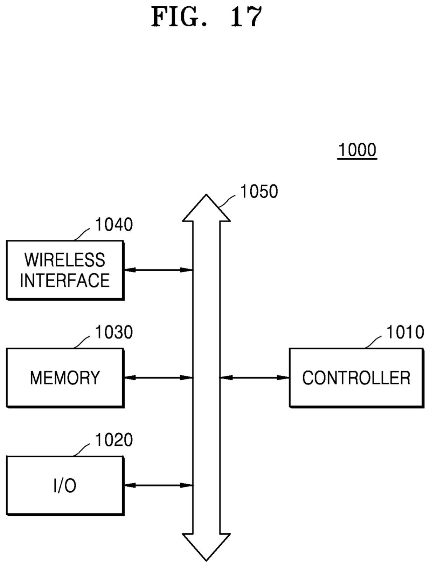

FIG. 17 is a block diagram illustrating an electronic device, according to some example embodiments.

Referring to FIG. 17, an electronic device 1000 may include a wireless communication device or a device capable of transmitting and/or receiving information in a wireless environment. The electronic device 1000 may include a controller 1010, an input/output device 1020, a memory 1030, and a wireless interface 1040, which may be connected to each other through a bus 1050.

The controller 1010 may include at least one of a microprocessor, a digital signal processor, or the like. The input/output device 1020 may include at least one of a keypad, a keyboard, or a display. The memory 1030 may be used to store a command executed by the controller 1010. For example, the memory 1030 may be used to store user data. The electronic device 1000 may use the wireless interface 1040 to transmit/receive data through a wireless communication network. The wireless interface 1040 may include an antenna and/or a wireless transceiver. In some embodiments, the electronic device 1000 may be used for a communication interface protocol of a third generation communication system, for example, code division multiple access (CDMA), global system for mobile communications (GSM), North American digital cellular (NADC), extended-time division multiple access (E-TDMA), and/or wide band code division multiple access (WCDMA). The electronic device 1000, including any portion thereof (e.g., at least one of the controller 1010, the input/output device 1020, the memory 1030, or the wireless interface 1040), may include any one of the semiconductor devices 100 to 107 according to some example embodiments described above or any modified combination thereof.

As described herein, any devices, systems, modules, portions, units, controllers, circuits, and/or portions thereof according to any of the example embodiments, and/or any portions thereof (including, without limitation, the DDI 500, the controller 502, the power supply circuit 504, the driver block 506, the memory block 508, the display apparatus 520, the MPU 522, the display panel 524, the CMOS SRAM device 700, the CMOS NAND circuit, the electronic device 900, the memory 910, the memory controller 920, the host 930, the electronic device 1000, the controller 1010, the input/output device 1020, the memory 1030, the wireless interface 1040, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

While a semiconductor device, a method of manufacturing the same, and an electronic device including the semiconductor device have been described with reference to the embodiments shown in the drawings, these are examples and it will be understood by one of ordinary skill in the art that various changes in form and details may be made therein without departing from the scope of the inventive concepts. Hence, the described example embodiments should be considered in descriptive sense only and not for purposes of limitation. The scope of the inventive concepts is defined only by the following claims, and all the equivalents of the embodiments may also be construed to be in the scope of the inventive concepts.

The semiconductor device described above has a small structure by including a van der Waals channel layer, and may also have low contact resistance and thus may have improved performance and/or reduced size without compromising performance.

## Claims

1. A semiconductor device, comprising:
a channel layer including a van der Waals material;
a source electrode structure and a drain electrode structure electrically connected to opposite ends of the channel layer, respectively;
a gate insulating layer on the channel layer; and
a gate electrode on the gate insulating layer,
wherein each of the source electrode structure and the drain electrode structure includes
an interlayer including a dopant and one of a semiconductor or an insulator, and
a metal layer on the interlayer.

2. The semiconductor device of claim 1, wherein the channel layer comprises a two-dimensional material, graphene, carbon nanotubes, or phosphorene,
in particular, wherein the channel layer comprises the two-dimensional material, and the two-dimensional material comprises at least one of MoS₂, WS₂, MoSe₂, MoTe₂, WSe₂, WTe₂, ReS₂, ReSe₂, PtS₂, PtSe₂, NbS₂, NbSe₂, SnS₂, SnS, SnSe, or SnSe₂.

3. The semiconductor device of claim 1 or 2, wherein the interlayer comprises Si, Ge, or a group III-V semiconductor compound, and/or
wherein a doping concentration of the dopant in the interlayer is 1×10¹³cm⁻³ or more, and/or
wherein a thickness of the interlayer is 1 nm or less.

4. The semiconductor device of any preceding claim, wherein, in each of the source electrode structure and the drain electrode structure,
the metal layer comprises a bottom surface facing the channel layer and a side surface extending upward from the bottom surface, and
the interlayer contacts the bottom surface and the side surface of the metal layer.

5. The semiconductor device of any preceding claim, wherein
the interlayer surrounds a top surface and a bottom surface of one end of the channel layer, and
the metal layer surrounds the interlayer.

6. The semiconductor device of any preceding claim, further comprising a seed layer between the channel layer and the gate insulating layer,
in particular, wherein the seed layer is formed of a same material as the interlayer.

7. The semiconductor device of any preceding claim, wherein
the channel layer comprises a first channel layer and a second channel layer spaced apart from each other, and
the gate electrode surrounds each of the first channel layer and the second channel layer.

8. The semiconductor device of claim 7, wherein, in each of the source electrode structure and the drain electrode structure, the interlayer comprises
a first interlayer surrounding one end of the first channel layer, and
a second interlayer surrounding one end of the second channel layer.

9. The semiconductor device of claim 8, wherein the gate insulating layer comprises
a first gate insulating layer surrounding the first channel layer, and
a second gate insulating layer surrounding the second channel layer.

10. The semiconductor device of claim 9, further comprising:
a first seed layer between the first channel layer and the first gate insulating layer and formed of a same material as the first interlayer; and
a second seed layer between the second channel layer and the second gate insulating layer and formed of a same material as the second interlayer.

11. A method of manufacturing a display device, the method comprising:
forming a channel layer including a van der Waals material;
forming, on the channel layer, an electrode structure including an interlayer including a semiconductor or an insulator and a dopant;
forming a gate insulating layer on the channel layer; and
forming a gate electrode on the gate insulating layer.

12. The method of claim 11, wherein the interlayer is formed based on using physical vapor deposition.

13. The method of claim 11 or 12, further comprising:
forming a seed layer between the channel layer and the gate insulating layer,
wherein the seed layer is formed of a same material as the interlayer.

14. The method of any of claims 11 to 13, wherein the forming of the electrode structure is performed after the forming of the gate insulating layer, or
wherein the forming of the gate insulating layer is performed after the forming of the electrode structure.

15. An electronic device, comprising:
a semiconductor device according to claim 1; and
a controller configured to control the semiconductor device.
